# EUROPÄISCHE PATENTSCHRIFT

(11) **EP 2 630 272 B1**
(45) Veröffentlichungstag und Bekanntmachung des Hinweises auf die Patenterteilung: **17.06.2015**
(21) Anmeldenummer: 11779095.6
(22) Anmeldetag: 21.10.2011
(51) Int. Cl.: C23C 16/04, C23C 14/56, C23C 16/44

(54) **VORRICHTUNG UND VERFAHREN ZUM BESCHICHTEN EINES SUBSTRATS**
METHOD AND APPARATUS FOR COATING A SUBSTRATE
APPAREIL ET PROCÉDÉ POUR FORMER UN REVÊTEMENT SUR UN SUBSTRAT

(30) Priorität: 21.10.2010 DE 102010049017
(43) Veröffentlichungstag der Anmeldung: 28.08.2013
(73) Patentinhaber: Bühler Alzenau GmbH, 63755 Alzenau (DE)
(72) Erfinder: ELLRICH, Jens, 65201 Wiesbaden (DE); NOVAK, Emmerich, Manfred, 14797 Kloster Lehnin (AT); CASPARI, Andreas, 66606 Wendel (DE)
(74) Vertreter: Pohlmann, Bernd Michael
(86) Internationale Anmeldenummer: PCT/EP2011/005322
(87) Internationale Veröffentlichungsnummer: WO 2012/052182

(56) Entgegenhaltungen:
- JP-A- 11 006 049
- JP-A- 56 090 975

## Beschreibung

Die Erfindung betrifft eine Vorrichtung und eine Vorrichtung zum Beschichten einer Oberfläche eines Substrats jeweils nach den Oberbegriffen der unabhängigen Ansprüche.

Das Beschichten von Substratoberflächen in der optischen und der optoelektronischen Industrie erfolgt typischerweise mit Hilfe chemischer und/oder physikalischer Gasphasen-Abscheidungsverfahren (CVD, PVD), bei denen in einer oder mehreren Partikelquelle(n) das gewünschte Beschichtungsmaterial in Form eines Partikeldampfes oder Gases erzeugt und auf der Substratoberfläche deponiert wird. Der Beschichtungsprozess erfolgt in der Regel in einer Bearbeitungskammer unter Vakuum oder in einer Schutzgasatmosphäre Während des Beschichtungsprozesses wird Beschichtungsmaterial auf die Substratoberfläche deponiert und bildet dort die gewünschte Beschichtung. Ein Teil des Beschichtungsmaterials gelangt jedoch an die Wände der Beschichtungskammer und an weitere, in der Beschichtungskammer befindlichen Abschirmeinrichtungen und bildet dort unerwünschte, aber unvermeidliche Ablagerungen. Mit zunehmender Betriebsdauer der Beschichtungsvorrichtung wächst die Schichtdicke dieser Ablagerungen an, bis sie aufgrund von Eigenspannungen abplatzen oder abbröckeln. Dann besteht die Gefahr der Verschmutzung der zu beschichtenden Substratoberflächen, was zu fehlerhaften Beschichtungen und/oder zu einem Bruch des Substratmaterials führen kann und einen erhöhten Ausschuss zur Folge hat.

Um diesem Problem zu begegnen, ist es bekannt, die dem Partikeldampf ausgesetzten Oberflächen im Innenraum der Beschichtungskammer (kammerwände, Abschirmvorrichtungen etc.) mit Hilfe besonderer Verfahren (z.B. Rauhstrahlen, Plasmabeschichtung) vorzubehandeln, um eine besonders gute Haftung der abgelagerten Beschichtungsmaterialien sicherzustellen und ein Abplatzen zu unterbinden Weiterhin wurde versucht, die Abschirmvorrichtungen in einer solchen Weise zu positionieren und zu formen, dass die evtl abplatzenden Beschichtungspartikel von den zu beschichtenden Substratoberflächen ferngehalten werden. Beide Lösungen stellten sich jedoch aus unzureichend heraus.

JP11006049 offenbart eine Vorrichtung (10) zum Beschichten einer Oberfläche eines Substrats (100) mit einer Bearbeitungskammer (11) und einer Partikelquelle (200). In dem Innenraum der Bearbeitungskammer (1) ist ein flächiges Abschirmgittern (72) aus beabstandet und parallel (Abbildung 3d) zu der dem Innenraum zugewandten Oberfläche vorgesehen. Es ist zwischen der Partikelquelle (5) und einer dem Innenraum zugewandten Oberfläche angeordnet und weist Öffnungen auf. Das Abschirmgitter besteht aus einem Streckgitter (Abbildung 4b). Ein Verfahren zum Beschichten einer Oberfläche unter Verwendung der Vorrichtung ist weiter offenbart.

Der Erfindung liegt somit die Aufgabe zugrunde, eine das Beschichten von Substratoberflächen in einer solchen Weise zu verbessern, dass die Gefahr einer Substratverschmutzung während des Beschichtungsprozesses reduziert wird.

Die Aufgabe wird durch die Merkmale der unabhängigen Ansprüche gelöst. Vorteilhafte Ausgestaltungen sind Gegenstand der Unteransprüche.

Danach ist im Innenraum der Bearbeitungskammer ein vorzugsweise flächenhaftes Abschirmgitter vorgesehen, das das zu beschichtende Substrat gegenüber einer Oberfläche, an der sich abgelagertes Beschichtungsmaterial ansammelt, abschirmt. Das Abschirmgitter ist in einer solchen Weise vor dieser Oberfläche angeordnet, dass das von der Partikelquelle (z.B. einem Sputtertarget) erzeugte gas- oder dampfförmige Beschichtungsmaterial durch die Öffnungen des Abschirmgitter hindurch auf die dahinter liegende Oberfläche gelangen und sich dort ablagern kann. Die Öffnungen des Abschirmgitters sind so dimensioniert, dass abplatzende Ablagerungen nicht durch das Abschirmgitter hinaus entweichen können, sondern zwischen dem Abschirmgitter und der zugeordneten Oberfläche zurückgehalten werden und von dort aus gezielt abgeführt werden können. Die Öffnungen sind wesentlich größer, also haben zumindest doppelt so große lichte Weite, als der durchschnittliche Durchmesser der Dampfpartikel, aber kleiner als die durch Abplatzen von Ablagerungen von der Oberfläche erzeugte Schuppen.

Auf diese Weise werden abgeplatzte Ablagerungen zuverlässig von dem zu beschichtenden Substrat ferngehalten, so dass Verschmutzungen der Substratoberfläche wirksam unterbunden werden.

Das Abschirmgitter ist vorzugsweise vor ausgewählten Bereichen der Innenwand der Bearbeitungskammer und/oder vor einem in der Bearbeitungskammer befindlichen Abschirmblech angeordnet. Weitere Abschirmgitter können direkt - d.h. unter Umgehung eines Abschirmblechs - an den Wänden weiterer in der Bearbeitungskammer vorgesehener Bauteile, Geräte etc. angeordnet werden.

Um die Schutzvorrichtung möglichst kompakt zu gestalten, verläuft das Abschirmgitter zweckmäßigerweise näherungsweise parallel und in einem geringen Abstand zu der abzuschirmenden Oberfläche. Zwischen dem Abschirmgitter und der abzuschirmenden Oberfläche ist ein Freiraum vorgesehen, in dem sich abplatzende Ablagerungen sammeln bzw. durch den diese Ablagerungen abgeführt werden können. Die Höhe dieses Freiraums beträgt typischerweise zwischen 2 und 10 mm, vorzugsweise etwa 5 mm. Um einen stabilen Aufbau zu gewährleisten, ist das Abschirmgitter vorteilhafterweise mit Hilfe von Abstandshaltern an der zugeordneten Oberfläche befestigt sein.

In einer bevorzugten Ausgestaltung der Erfindung umfasst die Beschichtungsvorrichtung eine Sammelkammer, in der die von der Oberfläche abplatzenden Ablagerungen gesammelt werden, so dass sie gemeinsam entfernt werden können.

Das erfindungsgemäße Verfahren zum Beschichten einer Oberfläche eines Substrats umfasst
- Aufnehmen des Substrats in einer Bearbeitungskammer während des Beschichtungsprozesses,
- Erzeugen von Beschichtungspartikeln (19) mit einer Partikelquelle,
- Eindringen lassen von Beschichtungspartikel in einen Bereich zwischen einem - Abschirmgitter, das zwischen der Partikelquelle und einer dem Innenraum zugewandten Oberfläche angeordnet ist, und der Oberfläche
- Zurückhalten von Ablagerungen, die von der Oberflächen abgeplatzt sind, in dem Bereich zwischen dem Abschirmgitter und der Oberfläche mittels des Abschirmgitters

Das Abschirmgitter besteht vorzugsweise - zumindest abschnittsweise - aus einem Streckgitter, Insbesondere einem Streckmetall. Bekanntermaßen ist ein Streckgitter ein Werkstück mit Öffnungen in der Oberfläche, die durch versetzte Schnitte unter gleichzeitiger streckender Verformung einer Platine erzeugt werden. Die Öffnungen sind erfingdungsgemäß in einer solchen Weise dimensioniert, dass einerseits die gas oder dampfförmigen Partikel durch das Streckmetall hindurch auf die dahinter liegenden Wand gelangen können, dass aber andererseits die evtl. von der Wand abplatzenden Ablagerungen nicht mehr zurück in den Beschichtungsbereich gelangen können. Vorzugsweise haben die Öffnungen eine lichte Weite zwischen 0,05 mm und 5mm, besonders bevorzugt eine lichte Weite zwischen 0,1 mm und 1 mm, womit eine besonders zuverlässige Zurückhaltung von abgeplatztem Material von den zu beschichtenden Substraten erreicht werden kann. Streckgitter, insbesondere Streckmetall ist einfach und preiswert herstellbar. Die Abschirmgitter aus Streckmetall können entweder als Verbrauchsartikel ausgeführt werden oder aber durch Sandstrahlen gereinigt und wieder verwendet werden. Als Materialien für das Streckmetall kommen beispielsweise legierte Stähle oder Nichteisen-Metalle in Frage, die auch oberflächenbehandelt und/oder beschichtet sein können.

Im Folgenden wird die Erfindung anhand eines in den Figuren dargestellten Ausführungsbeispiels näher erläutert. Dabei zeigen:
- Fig. 1a: eine schematische Schnittansicht durch eine Vorrichtung zur Substratbeschichtung, mit Innenwänden und Abschirmvorrichtungen, die mit Abschirmgittern versehen sind;
- Fig. 1b: eine Detailansicht eines Innenwand-Bereiches der Vorrichtung der Fig. 1a, gemäß dem in Fig. 1a markierten Ausschnitt Ib;
- Fig. 2: eine Aufsicht auf ein als Streckmetall ausgebildetes Abschirmgitter.

In den Zeichnungen sind einander entsprechende Elemente mit denselben Bezugszeichen bezeichnet. Die Zeichnungen stellen ein schematisches Ausführungsbeispiel dar und geben keine spezifischen Parameter der Erfindung wieder. Weiterhin dienen die Zeichnungen lediglich zur Erläuterung einer vorteilhaften Ausführungsform der Erfindung und sollen nicht in einer solchen Weise interpretiert werden, dass sie den Schutzbereich der Erfindung einengen

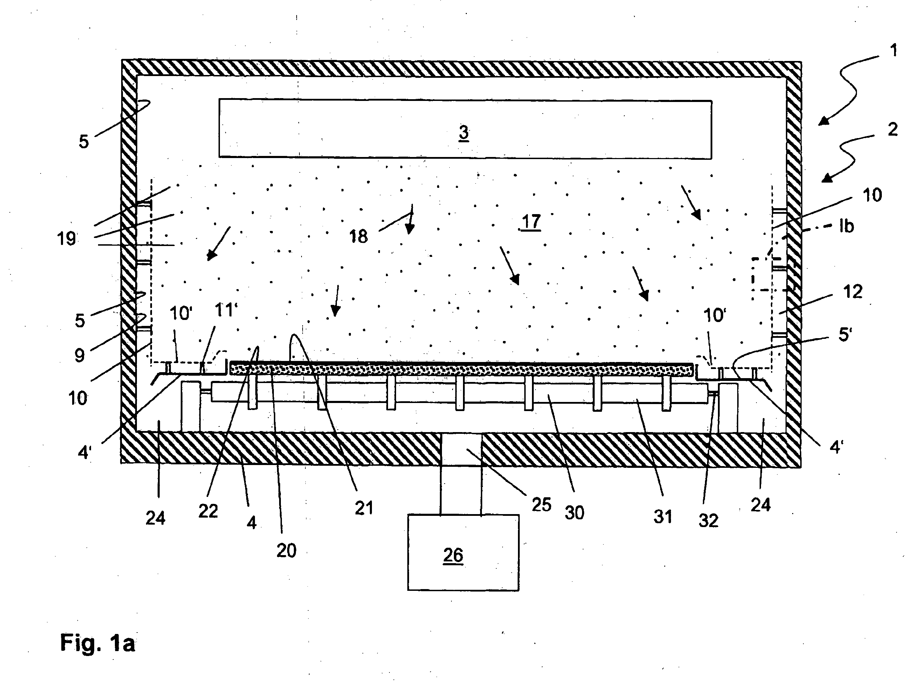

Figur 1a zeigt eine schematische Schnittansicht einer Vorrichtung 1 zum Beschichten einer Oberfläche 21 eines Substrats 20 mit Hilfe eines Sputterprozesses. Die Beschichtungsvorrichtung 1 umfasst eine Bearbeitungskammer 2, in deren Innenraum 17 eine oder mehrere Partikelquellen 3 zur Erzeugung der für die Beschichtung verwendeten dampfförmige Beschichtungspartikel 19 angeordnet sind. Die Dampfpartikel 19 können beispielsweise durch chemische Gasphasenabscheidung (CVD) erzeugt werden, wobei mehrere gasförmige Ausgangsstoffe miteinander reagieren, um die Partikel 19 in der gewünschten chemischen Zusammensetzung zu bilden. Weiterhin können die Dampfpartikel 19 durch physikalische Oasphasenabscheidungsverfahren (PVD) erzeugt werden. In diesem Fall werden in die Dampfpartikel 19 mit Hilfe von Laserstrahlen, magnetisch abgelenkten Ionen oder Elektronen, durch Lichtbogenentladung etc. aus einem aus dem Beschichtungsmaterial bestehenden Target herausgeschlagen, bewegen sich durch die Bearbeitungskammer 2 und lagern sich auf dem Substrat 20 und/oder auf anderen Oberflächen 5, 5' im Inneren der Bearbeitungskammer 2 ab, wo es zur Schichtbildung kommt. Der Beschichtungsprozess erfolgt im Vakuum, weswegen in der Wand 4 der Bearbeitungskammer 2 Anschlüsse 25 für Vakuumpumpen 26 vorgesehen sind.

Das Substrat 20 kann beispielsweise ein großformatiges Glassubstrat sein, das in der Beschichtungsvorrichtung 1 mit einem Mehrschichtsystem 22 für Solarapplikationen versehen werden soll. Das Substrat 20 wird auf einer Zuführvorrichtung 30 durch den von der Partikelquelle 3 erzeugten Strom dampfförmiger Beschichtungspartikel 19 hindurchbewegt, wobei die der Partikelquelle 3 zugewandte Oberfläche 21 des Substrats 20 beschichtet wird. Im Ausführungsbeispiel der Figur 1a wird die Zuführvorrichtung 30 durch drehbare Transportrollen 31 gebildet, die mit Hilfe von (in der Figur nicht gezeigten) Motoren angetrieben werden, um das Substrat 20 durch die Bearbeitungskammer 2 zu bewegen.

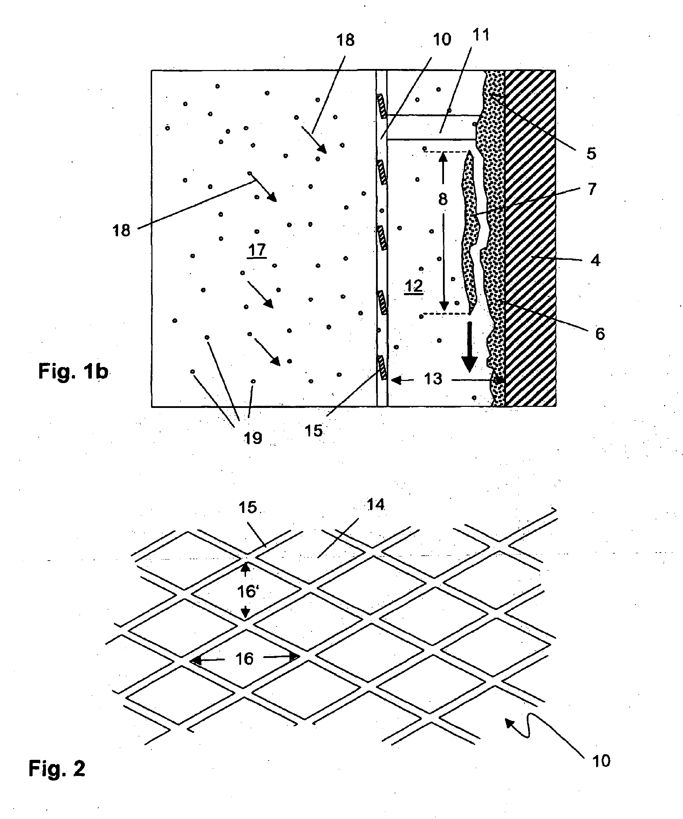

Neben der (erwünschten) Partikelablagerung auf der Substratoberfläche 21 setzen sich die Dampfparlikel 19 insbesondere auch an den Innenwänden 5 der Bearbeitungskammer 2 ab. Bei fortgesetztem Betrieb der Beschichtungsvorrichtung 1 erreichen die auf diesen Innenwänden 5 angesammelten Ablagerungen 6 eine große Schichtdicke und platzen in Form von Schuppen 7 ab (siehe hierzu die Detaildarstellung der Figur 1 b). Diese Schuppen 7 haben typischerweise die Form flacher Plättchen, können aber auch als kompakte Körner bzw. Bröckchen vorliegen. Die Größe 8 der Schuppen 7 liegt typischerweise zwischen einem Zehntelmillimeter und einigen Millimetern; die Schuppen 7 sind somit wesentlich größer als die durch die Partikelquelle 3 erzeugten Dampfpartikel 19. Um zu verhindern, dass die Schuppen 7 auf das Substrat 20 gelangen und Verunreinigungen des Substrats 20 und/oder der aufgetragenen Beschichtung 22 verursachen, sind ausgewählte Bereiche 9 (oder die gesamte Fläche) der Innenwand 5 der Bearbeitungskammer 2 mit Abschirmgittern 10 versehen. Das Abschirmgitter 10 verläuft näherungsweise parallel zur Innenwand 5, folgt also der Kontur der Innenwand 5, und ist mit Hilfe von Abstandshaltern 11 an der Wand 4 befestigt, so dass zwischen dem Abschirmgitter 10 und der Innenwand 5 ein Hohlraum 12 der Breite 13 gebildet wird.

Das Abschirmgitter 10 besteht aus einem Streckmetall. Streckmetall ist ein flächenhafter Werkstoff aus einem Metallblech oder einem Kunststoff mit Öffnungen 14, die durch versetzte Schnitte und streckender Verformung einer Ausgangsplatine erzeugt werden. Für den Einsatz als Abschirmgitter 10 besteht das Streckmetall vorzugsweise aus einem dünnen Stahlblech oder einem Blech aus einem Nichteisenmaterial. Das Streckmetall kann oberflächenbehandelt und/oder mit einer Oberflächenbeschichtung versehen sein.

Figur 2 zeigt eine Aufsicht auf das Abschirmgitter 10 aus Streckmetall mit rautenförmigen Öffnungen 14, die zwischen Stegen 15 gebildet sind. Die Breiten 16 und Höhen 16' der Öffnungen 14 sind wesentlich größer als der durchschnittliche Durchmesser der Dampfpartikel 19, aber kleiner als die durch Abplatzen von Ablagerungen erzeugten Schuppen 7. Somit können die von der Partikelquelle 3 In Richtung der Kammerwand 5 ausgesandten Dampfpartikel 19 (Pfeile 18 in Figur 1b) das Abschirmgitter 10 ohne große Behinderung passieren. Die von den Ablagerungen 6 der Innenwand 5 abgesprengten Schuppen 7 werden jedoch im Hohlraum 12 zwischen der Wand 5 und dem Abschirmgitter 10 eingefangen und können nicht in den jenseits der Abschirmgitters 10 gelegenen Bereich des Innenraums 17 der Bearbeitungskammer 2 entweichen (und somit auch keine Verschmutzungen auf dem Substrat 20 verursachen). Durch die Schwerkraft fallen die Schuppen 7 im Hohlraum 12 zwischen Wand 5 und Abschirmgitter 10 nach unten in eine Sammelkammer 24, aus der sie abgeführt werden können. Die Breite 13 des Hohlraums 12 beträgt typischerweise einige Millimeter, der Hohlraum 12 ist also breit genug, dass die von der Wandoberfläche 5 abgeplatzten Schuppen 7 ungehindert nach unten in die Sammelkammer 24 gelangen können.

Um die Dampfpartikel 19 möglichst ungehindert in den Hohlraum 12 zwischen Abschirmgitter 10 und Wand 4 eindringen zu lassen, kann das Streckmetall in einer solchen Weise geformt sein dass seine Stege 15 - wie in Figur 1b angedeutet - gegenüber der Ebene des Streckgitters gekippt sind. Weiterhin kann das Streckmetall mit steifigkeitserhöhenden Strukturen (Sicken etc.) versehen sein, um die Eigensteifigkeit des Abschirmgitters 10 zu erhöhen.

Die Dampfpartikel 19 lagern sich nicht nur auf der Substratoberfläche 21 und den Kammerwänden 5 ab, sondern auf allen Oberflächen 5', die dem Partikelstrom ungeschützt ausgesetzt sind. Um die Transportrollen 31 und ihre Lagerungen 32 gegenüber dem Strom der Beschichtungspartikel 19 abzuschirmen, sind die seitlich neben dem Substrat 20 liegenden Bereiche der Transportrollen 31 durch Abschirmvorrichtungen 4' aus einem Metallblech geschützt, die die verhindern, dass Dampfpartikel in diese Bereiche gelangen und die Funktionsfähigkeit der Zuführvorrichtung 30 beeinträchtigen. Auch auf diesen Abschirmvorrichtungen 4' sammeln sich im Beschichtungsbetrieb Ablagerungen 6 von Beschichtungsmaterial ab, die abplatzen und auf das Substrat 20 gelangen können. Um solche Verschmutzungen des Substrats 20 zu verhindern, sind die Abschirmvorrichtungen 4' ebenfalls mit Abschirmgittern 10' aus Streckmetall versehen, die mit Hilfe von Abstandshaltern 11' an den Abschirmvorrichtungen 4' befestigt sind.

Zusätzlich können auch weitere in der Bearbeitungskammer 2 befindliche Einbauten, Geräte etc. mit Abschirmgittern versehen sein, die direkt an der Außenwand dieser Einbauten, Geräte etc. oder an den zugehörigen Abschirmvorrichtungen befestigt sein können.

## Patentansprüche

1. Vorrichtung (1) zum Beschichten einer Oberfläche (21) eines Substrats (20),
- mit einer Bearbeitungskammer (2) zur Aufnahme des Substrats (20) während des Beschichtungsprozesses,
- und mit einer Partikelquelle (3) zur Erzeugung von Beschichtungspartikeln (19), wobei in einem Innenraum (17) der Bearbeitungskammer (2) ein Abschirmgitter (10, 10') vorgesehen ist, das zwischen der Partikelquelle (3) und einer dem Innenraum (17) zugewandten Oberfläche (5, 5') angeordnet ist und Öffnungen (14) aufweist, die wesentlich größer als der durchschnittliche Durchmesser der Dampfpartikel (19) aber kleiner als durch Abplatzen von Ablagerungen (6) von der Oberfläche (5, 5') erzeugte Schuppen (7) sind, **dadurch gekennzeichnet,**
**dass** das Abschirmgitter (10, 10') aus einem Streckgitter besteht, wobei das Streckgitter in einer solchen Weise geformt ist, dass seine Stege (15) gegenüber der Ebene des Streckgitters gekippt sind.

2. Vorrichtung (1) nach Anspruch 1,
**dadurch gekennzeichnet,**
**dass** das Abschirmgitter (10, 10') eine flächige Struktur hat.

3. Vorrichtung (1) nach Anspruch 2,
**dadurch gekennzeichnet,**
**dass** das Abschirmgitter (10, 10') näherungsweise parallel zu der Oberfläche (5, 5') angeordnet ist.

4. Vorrichtung (1) nach einem der Ansprüche 1 bis 3,
**dadurch gekennzeichnet,**
**dass** das Abschirmgitter (10, 10') beabstandet zu der Oberfläche (5, 5') angeordnet ist.

5. Vorrichtung (1) nach Anspruch 4,
**dadurch gekennzeichnet,**
**dass** der Abstand (13) zwischen Abschirmgitter (10, 10') und Oberfläche (5, 5') zwischen 2 und 10 mm beträgt.

6. Vorrichtung (1) nach einem der Ansprüche 1 bis 5,
**dadurch gekennzeichnet,**
**dass** das Abschirmgitter (10) zwischen der Partikelquelle (3) und einer dem Innenraum (17) der Bearbeitungskammer (2) zugewandten Innenwand (5) der Bearbeitungskammer (2) angeordnet ist.

7. Vorrichtung (1) nach einem der Ansprüche 1 bis 5,
**dadurch gekennzeichnet,**
**dass** das Abschirmgitter (10') an einer der Partikelquelle (3) zugewandten Oberfläche (5') einer im Innenraum (17) der Bearbeitungskammer (2) befindlichen flächenhaften Abschirmvörrichtung (4') angeordnet Ist.

8. Vorrichtung (1) nach einem der vorangehenden Ansprüche,
**dadurch gekennzeichnet,**
**dass** das Abschirmgittern (10, 10') mit Hilfe von Abstandshaltern (11, 11') an der Oberfläche (5, 5') befestigt ist.

9. Vorrichtung (1) nach einem der vorangehenden Ansprüche,
**dadurch gekennzeichnet,**
**dass** die Vorrichtung (1) eine Sammelkammer (24) zur Aufnahme der zwischen Abschirmgittern (10, 10') und Oberfläche (5, 5) gesammelten abgeplatzten Ablagerungen (7) umfasst.

10. Verfahren zum Beschichten einer Oberfläche (21) eines Substrats (20), mit
- Aufnehmen des Substrats (20) in einer Bearbeitungskammer (2) während des Beschichtungsprozesses,
- Erzeugen von Beschichtungspartikeln (19) mit einer Partikelquelle (3),
- Eindringen lassen von Beschichtungspartikel (19) in einen Bereich zwischen einem Abschirmgitter (10, 10'), das zwischen der Partikelquelle (3) und einer dem Innenraum (17) zugewandten Oberfläche (5, 5') angeordnet ist, und der Oberfläche (5,5')
- Zurückhalten von Ablagerungen (6), die von der Oberflächen (5,5') abgeplatzt sind, in dem Bereich zwischen dem Abschirmgitter (10, 10') und der Oberfläche (5. 5') mittels des Abschirmgitters (10, 10'),
**dadurch gekennzeichnet,**
**dass** ein als Streckgitter ausgebildetes Abschirmgitter (10) verwendet wird, das in einer solchen Weise geformt ist, dass seine Stege (15) gegenüber der Ebene des Streckgitters gekippt sind.

## Claims

1. Apparatus (1) for coating a surface (21) of a substrate (20),
- having a processing chamber (2) for receiving the substrate (20) during the coating process,
- and having a particle source (3) for producing coating particles (19),
wherein a shielding screen (10, 10') is provided in an interior (17) of the processing chamber (2), is arranged between the particle source (3) and a surface (5, 5') facing toward the interior (17) and has openings (14), which are significantly larger than the average diameter of the vapor particles (19), but smaller than flakes (7) produced by spalling of deposits (6) from the surface (5, 5'), **characterized**
**in that** the shielding screen (10, 10') consists of an expanded screen, wherein the expanded screen is formed in such a manner that the webs (15) thereof are tilted with respect to the plane of the expanded screen.

2. Apparatus (1) according to Claim 1,
**characterized**
**in that** the shielding screen (10, 10') has an areal structure.

3. Apparatus (1) according to Claim 2,
**characterized**
**in that** the shielding screen (10, 10') is arranged approximately parallel to the surface (5, 5').

4. Apparatus (1) according to one of Claims 1 to 3,
**characterized**
**in that** the shielding screen (10, 10') is arranged spaced apart from the surface (5, 5').

5. Apparatus (1) according to Claim 4,
**characterized**
**in that** the distance (13) between the shielding screen (10, 10') and the surface (5, 5') is between 2 and 10 mm.

6. Apparatus (1) according to one of Claims 1 to 5,
**characterized**
**in that** the shielding screen (10) is arranged between the particle source (3) and an inner wall (5) of the processing chamber (2) facing toward the interior (17) of the processing chamber (2).

7. Apparatus (1) according to one of Claims 1 to 5,
**characterized**
**in that** the shielding screen (10') is arranged on a surface (5'), facing toward the particle source (3), of an extensive shielding apparatus (4') located in the interior (17) of the processing chamber (2).

8. Apparatus (1) according to one of the preceding claims,
**characterized**
**in that** the shielding screen (10, 10') is fastened to the surface (5, 5') with the aid of spacers (11, 11').

9. Apparatus (1) according to one of the preceding claims,
**characterized**
**in that** the apparatus (1) comprises a collecting chamber (24) for receiving the spalled deposits (7) which have collected between the shielding screen (10, 10') and the surface (5, 5').

10. Process for coating a surface (21) of a substrate (20), including
- receiving the substrate (20) in a processing chamber (2) during the coating process,
- producing coating particles (19) using a particle source (3),
- allowing coating particles (19) to penetrate into a region between a shielding screen (10, 10'), which is arranged between the particle source (3) and a surface (5, 5') facing toward the interior (17), and the surface (5, 5'),
- detaining deposits (6), which have spalled from the surfaces (5, 5'), in the region between the shielding screen (10, 10') and the surface (5, 5') by means of the shielding screen (10, 10'),
**characterized**
**in that** use is made of a shielding screen (10) which is formed as an expanded screen and which is formed in such a manner that the webs (15) thereof are tilted with respect to the plane of the expanded screen.

## Revendications

1. Dispositif (1) destiné à revêtir une surface (21) d'un substrat (20),
- comportant une chambre de traitement (2) destinée à recevoir le substrat (20) pendant le processus de revêtement,
- et comportant une source de particules (3) destinée à générer des particules de revêtement (19), dans lequel il est prévu dans un espace intérieur (17) de la chambre de traitement (2) une grille de blindage (10, 10') qui est disposée entre la source de particules (3) et une surface (5, 5') tournée dans une direction opposée à l'espace intérieur (17) et comprend des orifices (14) qui sont sensiblement plus grands que le diamètre moyen des particules de vapeur (19) mais qui sont plus petits que des écailles (7) générées par écaillage de dépôts (6) de la surface (5, 5'), **caractérisé en ce que**
la grille de blindage (10, 10') est constituée d'une grille expansée, la grille expansée étant façonnée de telle manière que ses brins (15) soient inclinés par rapport au plan de la grille expansée.

2. Dispositif (1) selon la revendication 1, **caractérisé en ce que** la grille de blindage (10, 10') présente une structure plane.

3. Dispositif (1) selon la revendication 2, **caractérisé en ce que** la grille de blindage (10, 10') est disposée de manière approximativement parallèle à la surface (5, 5').

4. Dispositif (1) selon l'une quelconque des revendications 1 à 3, **caractérisé en ce que** la grille de blindage (10, 10') est expansée de la surface (5, 5').

5. Dispositif (1) selon la revendication 4, **caractérisé en ce que** la distance (13) entre la grille de blindage (10, 10') et la surface (5, 5') est comprise entre 2 et 10 mm.

6. Dispositif (1) selon l'une quelconque des revendications 1 à 5, **caractérisé en ce que** la grille de blindage (10) est disposée entre la source de particules (3) et une paroi interne (5) de la chambre de traitement (2), qui est disposée de manière à être tournée dans une direction opposée à l'espace intérieur (17) de la chambre de traitement (2).

7. Dispositif (1) selon l'une quelconque des revendications 1 à 5, **caractérisé en ce que** la grille de blindage (10') est disposée sur une surface (5') tournée dans une direction opposée à la source de particules (3), d'un dispositif de blindage (4') étendu se trouvant dans l'espace intérieur (17) de la chambre de traitement (2).

8. Dispositif (1) selon l'une quelconque des revendications précédentes, **caractérisé en ce que** la grille de blindage (10, 10') est fixée à la surface (5, 5') à l'aide d'éléments d'espacement (11, 11').

9. Dispositif (1) selon l'une quelconque des revendications précédentes, **caractérisé en ce que** le dispositif (1) comprend une chambre de collecte (24) destinée à recevoir les dépôts (7) écaillés collectés entre la grille de blindage (10, 10') et la surface (5, 5').

10. Procédé destiné à revêtir une surface (21) d'un substrat (20), consistant à
- recevoir le substrat (20) dans une chambre de traitement (2) pendant le processus de revêtement,
- générer des particules de revêtement (19) au moyen d'une source de particules (3),
- amener les particules de revêtement (19) à pénétrer dans une zone située entre une grille de blindage (10, 10'), qui est disposée entre la source de particules (3) et une surface (5, 5') tournée dans une direction opposée à l'espace intérieur (17), et la surface (5, 5'),
- retenir des dépôts (6) qui se séparent des surfaces (5, 5') dans la zone située entre la grille de blindage (10, 10') et la surface (5, 5') au moyen de la grille de blindage (10, 10'),
**caractérisé en ce qu'**on utilise une grille de blindage (10) réalisée sous la forme d'une grille expansée qui est façonnée de telle manière que ses brins (15) soient inclinés par rapport au plan de la grille expansée.
